(19) **Europäisches Patentamt / European Patent Office / Office européen des brevets**

(11) **EP 2 210 970 B1**

(12) **EUROPEAN PATENT SPECIFICATION**

(45) Date of publication and mention of the grant of the patent:
**29.03.2017 Bulletin 2017/13**

(51) Int Cl.:
*C25D 11/04* (2006.01)    *B29C 59/02* (2006.01)
*C25D 11/12* (2006.01)    *C25D 11/18* (2006.01)
*C25D 11/24* (2006.01)    *G02B 1/11* (2015.01)
*H01L 21/027* (2006.01)

(21) Application number: **08842262.1**

(22) Date of filing: **24.10.2008**

(86) International application number:
**PCT/JP2008/069376**

(87) International publication number:
**WO 2009/054513 (30.04.2009 Gazette 2009/18)**

(54) **STAMPER, PROCESS FOR PRODUCING THE SAME, PROCESS FOR PRODUCING MOLDING, AND ALUMINUM BASE DIE FOR STAMPER**

STEMPEL, VERFAHREN ZU SEINER HERSTELLUNG, VERFAHREN ZUR FORMHERSTELLUNG UND MATRIZE AUF ALUMINIUMBASIS FÜR DEN STEMPEL

MATRICE DE PRESSAGE, SON PROCÉDÉ DE FABRICATION, PROCÉDÉ DE FABRICATION DE MOULAGE ET MATRICE DE BASE EN ALUMINIUM POUR MATRICE DE PRESSAGE

(84) Designated Contracting States:
**AT BE BG CH CY CZ DE DK EE ES FI FR GB GR HR HU IE IS IT LI LT LU LV MC MT NL NO PL PT RO SE SI SK TR**

(30) Priority: **25.10.2007 JP 2007277855**
**30.07.2008 JP 2008196741**

(43) Date of publication of application:
**28.07.2010 Bulletin 2010/30**

(73) Proprietors:
• **Mitsubishi Rayon Co., Ltd.**
**Minato-ku**
**Tokyo 108-8506 (JP)**
• **KANAGAWA ACADEMY OF SCIENCE AND TECHNOLOGY**
**Kawasaki-shi,**
**Kanagawa-ken 213-0012 (JP)**
• **Nippon Light Metal Company, Ltd.**
**Tokyo 140-8628 (JP)**

(72) Inventors:
• **KOJIMA, Katsuhiro**
**Otake-shi**
**Hiroshima 739-0693 (JP)**
• **OKAMOTO, Eiko**
**Otake-shi**
**Hiroshima 739-0693 (JP)**

• **UOZU, Yoshihiro**
**Kanagawa 230-0053 (JP)**
• **TONE, Seiji**
**Hiroshima 739-0693 (JP)**
• **MASUDA, Hideki**
**Kawasaki-shi**
**Kanagawa 213-0012 (JP)**
• **YANAGISHITA, Takashi**
**Kawasaki-shi**
**Kanagawa 213-0012 (JP)**
• **KITA, Hiroaki**
**Inazawa-shi**
**Aichi 492-8144 (JP)**
• **ITO, Hisakazu**
**Shizuoka-shi**
**Shizuoka 421-3203 (JP)**
• **SHIRAI, Kota**
**Shizuoka-shi**
**Shizuoka 421-3203 (JP)**
• **SAEKI, Masayuki**
**Tokyo 140-8628 (JP)**

(74) Representative: **Hoffmann Eitle**
**Patent- und Rechtsanwälte PartmbB**
**Arabellastraße 30**
**81925 München (DE)**

(56) References cited:
**WO-A1-2008/001847**    **JP-A- 11 300 768**
**JP-A- 2005 156 695**    **JP-A- 2005 156 695**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

**(Cont. next page)**

JP-A- 2006 283 058    JP-B2- 2 891 344         US-A1- 2006 219 568

JP-A- 2006 283 058    JP-B2- 2 891 344         US-A1- 2006 219 568

## Description

Technical Field

The present invention relates to a stamper having alumina which has a microasperity structure and which is formed by anodization on the surface thereof and is suitably used for production of, for example, an antireflection article and the like, a method for producing the same, and a method for producing a molded material.

This application is based upon and claims the benefit of priority from prior Japanese Patent Application Nos. 2007-277855 filed in the Japanese Patent Office on October 25, 2007, and 2008-196741 filed in the Japanese Patent Office on July 30, 2008.

Background Art

In recent years, the benefit of a material having a microasperity structure with a period not greater than the wavelength of visible light on the surface thereof has drawn attention since it exhibits an antireflection function, a lotus effect, and the like. Particularly, a microasperity structure called a moth-eye structure is known as exhibiting an effective antireflection function since its refractive index gradually increases from the refractive index of air to the refractive index of a material.

As a method of forming a microasperity structure on a material surface, a method of directly processing the surface of a material, a transcription method of transcribing this structure using a stamper having a negative structure corresponding to the microasperity structure, and the like are possible. The latter method is superior from the perspectives of productivity and economy. As a method of forming a negative structure on a stamper, an electron beam drawing method, a laser interference method, and the like are known. However, in recent years, alumina having a microasperity structure that is formed by anodization has drawn attention as a stamper which can be more easily produced (see, Patent Citation 1, for example). Such anodized alumina is one in which a microasperity structure is formed on an oxide coating film (alumite) of aluminum, and which is formed on the surface thereof by anodizing a prototype aluminum mold having a high aluminum purity.

Moreover, a method of producing a prototype mold after depositing aluminum onto a substrate is possible. However, in order to produce highly regular porous alumina, it is necessary to add Si, Ti, or Mg in aluminum so as to suppress an increase in the crystal-grain diameter (see Patent Citations 2 and 3).

Patent Citation 1: Japanese Patent Application Laid-Open No. 2005-156695
Patent Citation 2: Japanese Patent Application Laid-Open No. 2003-043203
Patent Citation 3: Japanese Patent Application Laid-Open No. 2005-232487

Disclosure of the Invention

Technical Problem

However, when a molded material for optical use including an antireflection article, such as, for example, an antireflection coating (including an antireflection film and an antireflection sheet) is produced by the transcription method using a stamper having anodized alumina on the surface thereof, there are the following problems. When a prototype aluminum mold is a rolled material, rolling marks may be transcribed onto a transcribed surface formed by transcription. Moreover, a treatment for raising the regularity of pore arrangement may increase the unevenness heights of crystal grains, which is transcribed, thus forming a macroscopic unevenness which can be observed with the naked eye. Furthermore, although the steps of crystal grains are in a level such that the macroscopic unevenness is not observed with the naked eye, since the crystal faces have different anodizabilities, color unevenness occurs in the molded material. Thus, there was a case where a molded material suitable for optical use was unobtainable.

Moreover, in the method of producing a prototype mold after depositing aluminum on a substrate, the aluminum purity decreases when Si, Ti, or Mg is added therein so as to obtain a flat deposition film. Therefore, unevenness on the order of micrometers resulting from dropout of intermetallic compounds of alloy components is formed on the surface of porous alumina by anodization. When such a prototype mold is used as a stamper, there are many problems in that unevenness on the order of micrometers is also transcribed, which is likely to cause an increase in haze on the transcribed film.

The present invention has been made in view of the above-described circumstances and an object of the present invention is to provide a stamper which has anodized alumina formed on the surface thereof and which will not cause a macroscopic unevenness or color unevenness on the transcribed surface; a method for producing the same; and a method for producing a molded material without a macroscopic unevenness or color unevenness on the transcribed surface thereof by using such a stamper.

Technical Solution

As the result of intensive investigation, the present inventors have found that aluminum used in a prototype mold for such a stamper is a polycrystalline body including a plurality of single crystals, and since the single crystals have different crystal faces being exposed to the surface and have different anodization rates or solubility rates in an acid solution depending on their crystal face, such a macroscopic unevenness that crystal grain boundaries are observable with the naked eye appears in a stamper formed from aluminum having a large crystal-grain size.

Moreover, even when the oxide coating film thickness obtained after a first anodization is controlled to be in such a level that unevenness is not identified with the naked eye, there was a problem in that color unevenness occurred on the transcribed surface.

Therefore, the present inventors arrived at the present invention upon discovering that the use of a prototype aluminum mold, as a material for a stamper, which is processed by a forging treatment or the like, for example, so as to have an average crystal-grain diameter of 1 mm or less and an arithmetic mean surface roughness Ra of 0.05 $\mu$m or less could enable the production of a stamper which has anodized alumina on the surface thereof and which will not cause a macroscopic unevenness or color unevenness on the transcribed surface, and that the use of such a stamper could provide a molded material without a macroscopic unevenness or color unevenness on the transcribed surface thereof.

A stamper of the present invention is defined by claim 1.

The height difference of the unevenness due to the crystal grain boundary on the surface of the stamper of the present invention is preferably 600 nm or less.

The prototype aluminum mold has an aluminum purity of 99.5% or more, and preferably contains 0.04% or less by mass of silicon, 0.06 % or less by mass of iron, and 0.01% or less by mass of copper with respect to 100% by mass of the prototype aluminum mold.

The prototype aluminum mold is preferably subjected to a forging treatment.

The average crystal-grain diameter is 200 $\mu$m or less, and preferably 150 $\mu$m or less. Since an average crystal-grain diameter beyond 1 mm causes a macroscopic unevenness or color unevenness, such an average crystal-grain diameter is not suitable for use as an antireflection article.

The forging treatment is preferably hot forging or a combination of hot forging and cold forging.

A method for producing a stamper according to the present invention is defined by claim 8.

The height difference of the unevenness due to the crystal grain boundary on the surface of the stamper of the present invention is preferably 600 nm or less.

A method for producing a molded material according to the present invention includes: disposing an active energy ray-curable composition between the above-mentioned stamper and a transparent substrate; irradiating the active energy ray-curable composition with an active energy ray in a state where the active energy ray-curable composition is in contact with the stamper, thus curing the active energy ray-curable composition; and releasing a cured material from the stamper, thus producing a molded material in which a microasperity structure formed from the cured material of the active energy ray-curable composition is formed on the surface of the transparent substrate.

A method for producing a molded material according to the present invention includes: disposing an active energy ray-curable composition between the above-mentioned stamper and a transparent substrate; transcribing the microasperity structure on the surface of the stamper to the active energy ray-curable composition and releasing the stamper; and irradiating the active energy ray-curable composition with an active energy ray, thus curing the active energy ray-curable composition and producing a molded material in which a microasperity structure formed from the cured material of the active energy ray-curable composition is formed on the surface of the transparent substrate.

In the present invention, as a preferred specific example of the molded material, an antireflection article such as antireflection coating (including an antireflection film and an antireflection sheet) can be offered.

Advantageous Effects

According to the present invention, it is possible not only to provide a stamper which has anodized alumina formed on the surface thereof and which will not cause macroscopic unevenness or color unevenness on the transcribed surface, but also to provide a method for producing a molded material using such a stamper.

Brief Description of the Drawings

FIG. 1 is an explanatory diagram for explaining a method for producing a stamper;

FIG. 2 is a sectional diagram showing an example of a pore shape formed on the surface of the stamper;

FIG. 3 is a sectional diagram showing another example of a pore shape formed on the surface of the stamper;

FIG. 4 is a sectional diagram showing a further example of a pore shape formed on the surface of the stamper; and

FIG. 5 is a schematic configuration diagram showing an example of a molded material-production apparatus for continuously producing a molded material having a microasperity structure using the roll mold obtained in Example 2.

Explanation of Reference

10: PROTOTYPE ALUMINUM MOLD

11, 14: PORE

12, 15: OXIDE COATING FILM

13: PORE GENERATING POINTS

20: STAMPER (HAVING ANODIZED ALUMINA FORMED ON ITS SURFACE)

30: MOLDED MATERIAL PRODUCTION APPARATUS

31: ROLL MOLD

32: TRANSPARENT SUBSTRATE

33: CURABLE COMPOSITION

34: MOLDED MATERIAL (TRANSPARENT SHEET)

35: TANK

36: NIP ROLLER

37: PNEUMATIC CYLINDER

38: ULTRAVIOLET IRRADIATION APPARATUS

39: RELEASE ROLLER

Best Mode for Carrying Out the Invention

Hereinafter, the present invention will be described in detail.

A stamper of the present invention, namely a stamper having anodized alumina on the surface thereof, is formed from a prototype aluminum mold having an aluminum purity of 99.5% or more, an average crystal-grain diameter of 1 mm or less, and an arithmetic mean surface roughness Ra of 0.05 $\mu$m or less. The stamper has a microasperity structure with a period not greater than the wavelength of visible light on the surface thereof.

In the present specification, the "period" of the microasperity structure refers to the distance from the center of a recess (pore) of the microasperity structure to the center of another pore adjacent thereto.

(Prototype Aluminum Mold)

The prototype aluminum mold of the present invention preferably has an aluminum purity of 99.5% or more, more preferably 99.8% or more, still more preferably 99.9% or more, and particularly preferably 99.95% or more. If the purity is below 99.5%, an asperity structure with a size that causes scattering of visible light is likely to be formed on an obtained stamper due to segregation of impurities, or the pores are not likely to be formed on a vertical shape. A stamper formed from such a prototype aluminum mold is not suitable for production of a molded material for optical use, such as, for example, an antireflection article. The use of high-purity aluminum enables achieving a more regular microasperity structure and reducing the danger of a rough surface due to segregation/dropout of impurities, thus expecting improvement in mold releasing properties.

The prototype aluminum mold which is a material for the stamper of the present invention has an arithmetic mean surface roughness Ra of 0.05 $\mu$m or less and an average crystal-grain diameter of 1 mm or less.

Here, the average crystal-grain diameter is an average equivalent circular diameter that is calculated for 100 or more crystal grains arbitrarily selected on the surface of the prototype aluminum mold. The crystal grains on the surface can be observed with an optical microscope or the like, and the average equivalent circular diameter is calculated using image analysis software, for example, such as, "Image-Pro PLUS" (Trade name of Nippon Roper Co., Ltd.). Prior to observing the surface of the prototype aluminum mold with an optical microscope or the like, it is preferable to polish the surface of the prototype aluminum mold and further to subject it to an etching treatment.

Although the average crystal-grain diameter of the prototype aluminum mold is 1 mm or less, the average diameter is preferably 300 $\mu$m or less, more preferably 0.05 $\mu$m or more and 200 $\mu$m or less, and still more preferably 1 $\mu$m or more and 150 $\mu$m or less. In a stamper formed from a prototype aluminum mold having an average crystal-grain diameter of beyond 1 mm, a macroscopic unevenness which can be observed with the naked eye is likely to appear. As a result, a macroscopic unevenness or color unevenness is likely to be formed on the transcribed surface which is formed from this stamper. Such a stamper is not suitable for production of a molded material for optical use, for example, such as, an antireflection article. On the other hand, if the average crystal-grain diameter is below 0.05 μm, it not only makes the production difficult, but also pores are formed across the crystal grain boundaries. Thus, there is a danger of disrupting the microasperity structure.

As a method for producing a prototype aluminum mold having an average crystal-grain diameter of 1 mm or less and an arithmetic mean surface roughness Ra of 0.05 μm or less, a method is suitable in which an aluminum ingot (cast lump) is first subjected to a forging treatment or the like so that the average crystal-grain diameter of aluminum is uniformly refined to be 1 mm or less, and the aluminum ingot is then processed into a desired form such as a planar form, a solid cylindrical form, or a hollow cylindrical form by a method such as cutting or machining, thus obtaining a prototype aluminum mold by polishing or the like so as to have an arithmetic mean surface roughness Ra of 0.05 μm or less.

In order to obtain a fine uniform structure, a processing method capable of applying a higher degree of processing to a raw material is preferable. In the case of a rolling treatment, since a processing direction is restricted to one direction, there is a limit in the degree of processing obtainable depending on the ingot size and the prototype mold size. On the other hand, in the case of a forging treatment, since it is possible to freely change the processing direction, it is possible to apply a higher degree of processing to a raw material than the rolling treatment. As a result, the forging treatment is better able to obtain a fine uniform structure than the rolling treatment. Moreover, in the case of the rolling treatment, since the processing direction is restricted to one direction, a streaky nonuniform structure may be formed along the rolling direction. When a stamper is produced using a prototype aluminum mold having such a nonuniform structure, the nonuniform structure may appear in a macroscopic pattern. Thus, a nonuniform macroscopic pattern may occur on the transcribed surface which is formed from such a stamper. Therefore, such a stamper is not suitable for production of a molded material for optical use, for example, such as an antireflection article. For this reason, it is necessary to apply processing for removing the nonuniform structure. Thus, the forging treatment is preferable in that such processing is not necessary. The prototype aluminum mold according to the present invention, whose arithmetic mean surface roughness Ra is 0.05 μm or less may be a non-rolled prototype aluminum mold which has not been subjected to a rolling treatment, or a prototype aluminum mold which has been subjected to a rolling treatment, and in which a nonuniform structure resulting from the rolling treatment is removed.

Equation 1

The arithmetic mean roughness (Ra) is derived from Equation below.

$$Ra = \frac{1}{\ell} \int_0^\ell |f(x)| \, dx$$

(where 1 is a reference length)

As the content of minor components which are inevitably contained during production in 100% by mass of the prototype aluminum mold, it is preferable that the content of silicon is 0.04% or less by mass, the content of iron is 0.06% or less by mass, and the content of copper is 0.01% or less by mass. If the content of minor components inevitably contained during production is greater than the above-mentioned value, portions where pores are not formed may appear, thus degrading the performance of the transcribed product obtained after it is used as a stamper. Specifically, the performance degradation may be the inability to make reflectance sufficiently low and degradation of transparency.

[Hot Forging]

A high-purity aluminum ingot (cast lump) is likely to become a nonuniform coarse structure, and is subjected to hot forging in order to obtain a fine uniform structure by destroying and recrystallizing the nonuniform coarse structure of this ingot. Prior to subjecting it to forging, a casting raw material being cut is fed into a heating furnace to be heated to 400 to 500°C before forging. The heating temperature at that time is important in making the structure uniform and refined. The raw material heated to 400 to 500°C is subjected to free forging to produce a forged product. If the heating temperature at that time is beyond 500°C, recrystallized grains during the hot forging are likely to become coarse. On the contrary, if the heating temperature is below 400°C, the coarse structure of the ingot is likely to remain as a nonuniform mark, and deformation resistance during the forging will increase, whereby cracks are likely to occur in a forged product or a mold. The heating is maintained for about 1 hour in order to make temperature uniform. The greater a forging ratio is taken, the harder the nonuniform coarse structure of the ingot will remain. If it is assumed that (1/2U-2S) or (2S-1/2U) is one cycle, the number of forging cycles is preferably 2 or more, more preferably 3 or more, and particularly preferably 4 or more. However, if the number of forging cycles is great, the temperature of a forged product will decrease greatly, and thus, the temperature may become lower than the crystallization temperature. Therefore, when the heating temperature becomes lower than 350°C during the hot forging, it is necessary to reheat the raw material to 400°C or more.

[Cold Forging]

Cold forging is performed in order to further refine the fine uniform structure obtained by hot forging. The raw material is cooled to room temperature or lower. The raw material is crushed in the vertical direction by die forging to produce a forged product. Alternatively, a forged product may be produced by free forging. Since accumulation of strain by cold forging aims to obtain a fine structure after a later heat treatment, the greater the forging ratio is taken within a range where it does not cause defects such as cracks, the easier it is to obtain a finer structure. If it is assumed that (1/2U-2S) or (2S-1/2U) is one cycle, the forging ratio is preferably 1 cycle or more and 3 cycles or less, and more preferably 2 cycles or more and 3 cycles or less. If the forging ratio is beyond 3 cycles, cracks are likely to become conspicuous. Even if the forging ratio is 3 cycles or less, when the raw material generates heat by the forging and the temperature exceeds 200°C, the strain will be gradually released at that point in time, and it becomes hard to obtain a fine structure after a heat treatment. For this reason, when the temperature appears to exceed 200°C, it is necessary to stop the forging temporarily and conduct air-cooling, water-cooling, or the like, thus suppressing releasing of strain.
Although the forging is performed in this way, it is preferable to perform hot forging, and more preferably, hot forging and cold forging are performed in combination.

[Heat Treatment]

A heat treatment is performed in order to cause recrystallization of the strain accumulated in the forged product to take place, thus obtaining uniform fine crystal grains. Since the forged product has accumulated therein strain which has been introduced during processing, it is possible to generate a number of fine recrystallized grains at the same time with this strain used a drive force, thus obtaining uniform and fine crystal grains. The heat treatment temperature is preferably 300°C to 500°C, and more preferably 300°C to 400°C. If the temperature is lower than 300°C, there is a possibility that a part of the forged structure still remains. On the contrary, if the temperature is higher than 500°C, the growth of recrystallized grains is accelerated considerably, and thus crystal grains become large. Moreover, the processing time is preferably 30 minutes or more, and more preferably 1 hour or more. If the processing time is less than 30 minutes, there is a problem in that the recrystallization is not completed and the forged structure remains.
The prototype aluminum mold obtained in this way is provided for production of a stamper, typically after being subjected to a mirror finishing treatment by a method, for example, such as mechanical polishing, buff polishing, chemical polishing, or electrochemical polishing such as electrolytic polishing.

[Stamper Having Anodized Alumina Formed on Its Surface]

As a method for producing a stamper having anodized alumina having a microasperity structure on the surface thereof using the above-mentioned prototype aluminum mold, a method may be mentioned in which the following steps are sequentially performed: (a) a first oxide coating film forming step of anodizing a prototype aluminum mold whose surface is mirror-finished in an electrolytic solution and at a constant voltage to form an oxide coating film; (b) an oxide coating film removing step of removing the oxide coating film thus formed to form pore generating points for anodization; (c) a second oxide coating film forming step of reanodizing an intermediate aluminum mold having the pore generating points formed thereon (where the intermediate aluminum mold refers to the prototype aluminum mold which has been subjected to a pore formation treatment and which is in a stage prior to becoming a stamper) in an electrolytic solution to form an oxide coating film having pores at the pore generating points; and (d) a pore diameter enlarging step of enlarging the diameters of the pores thus formed. In this case, it is preferable to perform (e) a repeating step of repeating the (c) second oxide coating film forming step and the (d) pore diameter enlarging step subsequently to the (d) pore diameter enlarging step.
According to such a method, pores having a tapered shape such that diameters thereof gradually decrease in a depth direction from an opening thereof are regularly formed on the surface of the prototype aluminum mold having a mirror-finished surface. As a result, it is possible to obtain a stamper having anodized alumina having a microasperity structure formed on the surface thereof.

(a) First Oxide Coating Film Forming Step

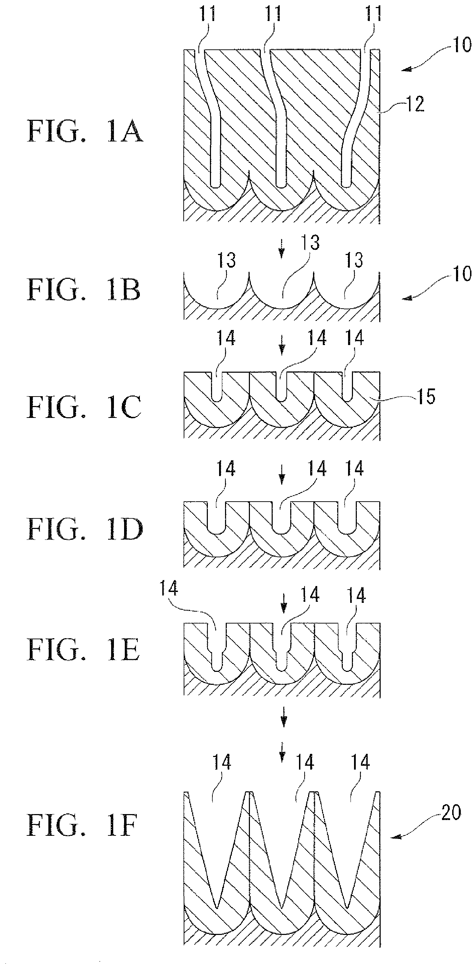

In the first oxide coating film forming step (a) (hereinafter, sometimes, referred to as (a) step), a prototype aluminum mold whose surface is mirror-finished is anodized in an electrolytic solution and at a constant voltage, whereby an oxide coating film 12 having pores 11 is formed on the surface of the prototype aluminum mold 10 as shown in FIG. 1A. Examples of the electrolytic solution being used include an acidic electrolytic solution and an alkaline electrolytic solution, and an electrolytic solution is preferable. Moreover, as the acidic electrolytic solution, sulfuric acid, oxalic acid, a mixture thereof, and the like may be used.

When oxalic acid is used as the electrolytic solution, the concentration of the oxalic acid is preferably 0.7 M or less. If the concentration of oxalic acid is beyond 0.7 M, the anodization current becomes too high, and the surface of the oxide coating film may become rough.

Moreover, when the anodization voltage is 30 to 60 V, a stamper which has anodized alumina on the surface thereof can be obtained, the anodized alumina having pores with a highly regular period of about 100 nm. If the anodization voltage is higher or lower than this range, the regularity tends to decrease, and the period may become greater than the wavelength of visible light.

The temperature of the electrolytic solution is preferably 60°C or less, and more preferably 45°C or lower. If the temperature of the electrolytic solution is beyond 60°C, a so-called "burning" phenomenon is likely to take place, and the pores may be destroyed or the surface may melt and disrupt the regularity of the pores.

When sulfuric acid is used as the electrolytic solution, the concentration of sulfuric acid is preferably 0.7 M or less. If the concentration of sulfuric acid is beyond 0.7 M, the current may become too high to be able to maintain a constant voltage.

When the anodization voltage is 25 to 30 V, a stamper which has anodized alumina on the surface thereof can be obtained, the anodized alumina having pores with a highly regular period of about 63 nm. If the anodization voltage is higher or lower than this range, the regularity tends to decrease, and the period may become greater than the wavelength of visible light.

The temperature of the electrolytic solution is preferably 30°C or less, and more preferably 20°C or lower. If the temperature of the electrolytic solution is beyond 30°C, a so-called "burning" phenomenon is likely to take place, and the pores may be destroyed or the surface may melt to disrupt the regularity of the pores.

In the (a) step, the thicker oxide coating film can be obtained with the longer anodization time, and it is thus possible to improve the regularity of pore arrangement. In this case, it is preferable to make the oxide coating film have a thickness of 30 $\mu$m or less, whereby the macroscopic unevenness due to the crystal grain boundary can be suppressed more, and a stamper which is more suitable for production of a molded material for optical use can be obtained. The thickness of the oxide coating film is more preferably 1 to 10 $\mu$m, and still more preferably 1 to 3 $\mu$m. The thickness of the oxide coating film can be observed with a field emission scanning electron microscope or the like.

((b) Oxide Coating Film Removing Step)

Subsequently to the above-mentioned (a) step, the oxide coating film 12 formed by the (a) step is removed, thus forming regular depressions corresponding to the bottom (called a barrier layer) of the removed oxide coating film 12, namely pore generating points 13 as shown in FIG. 1B ((b) oxide coating film removing step (hereinafter, sometimes, referred to as (b) step)). In this manner, by removing first the formed oxide coating film 12 to form the pore generating points 13 for anodization, it is possible to improve the regularity of pores which will be formed finally (see, Masuda, Applied Physics, vol. 69, No. 5, p. 558 (2000), for example).

As a method of removing the oxide coating film 12 porous alumina film, a method may be mentioned in which alumina is dissolved in a solution that does not dissolve aluminum but dissolves alumina, thus removing alumina. As an example of such a solution, a mixture liquid of chromic acid/phosphoric acid can be mentioned.

((c) Second Oxide Coating Film Forming Step)

Subsequently, the intermediate aluminum mold 10 having the pore generating points 13 formed thereon is reanodized in an electrolytic solution and at a constant voltage, thus forming an oxide coating film again ((c) second oxide coating film forming step (hereinafter, sometimes, referred to as (c) step)). In the (c) step, anodization may be performed under the same conditions (for example, an electrolytic solution concentration, an electrolytic solution temperature, an anodization voltage, and the like) as in the (a) step.

In this way, as shown in FIG. 1C, it is possible to form an oxide coating film 15 having cylindrical pores 14 formed thereon. In the (c) step, the deeper pores can be obtained with the longer anodization time. For example, in the case of producing a stamper for production of a molded material for optical use such as an antireflection article, the oxide coating film formed in this step may have a thickness of about 0.01 to 0.5 $\mu$m. However, it is not necessary to form the oxide coating film as thick as in the (a) step.

((d) Pore Diameter Enlarging Step)

Subsequently to the (c) step, (d) a pore diameter enlarging step of enlarging the diameters of the pores 14 formed in the (c) step is performed, thus enlarging the diameters of the pores 14 to be greater than the case of FIG. 1C as shown in FIG. 1D.

As a specific method of a pore diameter enlarging treatment, a method may be mentioned in which the aluminum mold is dipped in a solution that dissolves alumina, thus enlarging, by etching, the diameters of the pores formed in the (c) step. As an example of such a solution, an aqueous phosphoric acid solution of 5% by mass can be mentioned. The longer the (c) pore diameter enlarging step, the greater becomes the pore diameter.

((e) Repeating Step)

Subsequently, the (c) step is performed again to process the pores 14 so as to have a 2-staged cylindrical form with different diameters as shown in FIG. 1E, and thereafter, the (d) step is performed again. In this manner, by (e) a repeating step (hereinafter, sometimes, referred to as (e) step) of repeating the (c) step and the (d) step, it is possible to process the pores 14 so as to have a tapered shape such that diameters thereof gradually decrease in the depth direction from an opening thereof as shown in FIG. 1F. As a result, it is possible to obtain a stamper 20 in which anodized alumina having a regular micro asperity structure formed thereon is formed on the surface thereof.

In this case, by appropriately setting the conditions in the (c) step and the (d) step, for example, the anodization time and the pore diameter enlarging treatment time, it is possible to form pores having various shapes. Therefore, these conditions may be appropriately set depending on the purpose or the like of a molded material that is to be produced from the stamper. Moreover, when the stamper is used for producing an antireflection article such as an antireflection coating, since the period or depth of the pores can be arbitrarily changed by appropriately setting the conditions in this manner, it is also possible to design an optimum refractive index profile.

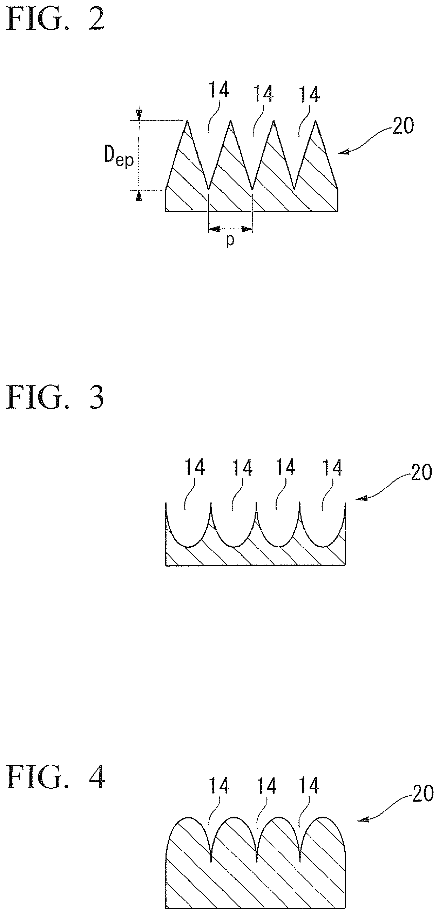

Specifically, when the (c) step and the (d) step are repeated under the same conditions, pores 14 having an approximately conical shape as shown in FIG. 2 are formed. However, by appropriately changing the processing time of the (c) step and the (d) step, it is possible to appropriately form pores 14 having a reversed bell shape as shown in FIG. 3, pores 14 having a sharp-pointed shape as shown in FIG. 4, and the like.

Although the more the number of repetition cycles in the (e) step, the smoother will the tapered shape of the pores formed, the number of repetition cycles of the (c) and (d) steps is preferably 3 or more, and more preferably 5 or more. If the number of repetition cycles is 2 or less, the pore diameter tends to decrease stepwise. When an antireflection article such as an antireflection coating is produced from such a stamper, there is a possibility of deterioration in its reflectance reduction effect.

Moreover, the height of an unevenness due to the crystal grain boundary in the mold of the present invention is preferably 600 nm or less, and more preferably 500 nm or less. If the height of the unevenness due to the crystal grain boundary is 600 nm or more, when the microasperity structure of the mold is transcribed, a macroscopic unevenness resulting from the unevenness heights of the crystal grain boundary of aluminum which is a raw material of the mold is also transcribed onto a transcribed surface, thus deteriorating the appearance. Although there is no particular lower limit to the height of the unevenness due to the crystal grain boundary, if the height is too small, the anodization time in the first oxide coating film forming step during the producing of the mold becomes too short. Thus, there is a case where the regularity of pore arrangement is degraded, and it is thus unable to obtain an intended asperity structure. Therefore, in order to control the height of the unevenness due to the crystal grain boundary to be in the above-mentioned range, it is preferable to control the thickness of the oxide coating film in the first oxide coating film forming step to be in the above-mentioned range.

Here, the height of the unevenness due to the crystal grain boundary is calculated by the following method.

First, the surface of the mold is observed with a scanning white-light interferometer 3D Profiler System, "New View 6300" (Trade name of Zygo Corp.) and the visual fields are combined to obtain observation results for a 10 mm-square area. The unevenness heights of crystal grain boundaries are measured at arbitrary 10 points selected from the 10 mm-square area, and the mean value thereof was used as "the height of the unevenness due to the crystal grain boundary." Moreover, in the present invention, the "height" and "depth" of the unevenness due to the crystal grain boundary have the same meaning.

The stamper of the present invention thus produced has a number of regular pores formed thereon and thus has a microasperity structure on the surface thereof. Particularly, when the period of this microasperity structure corresponds to the period not greater than the wavelength of visible light, namely 400 nm or less, such a surface constitutes a so-called moth-eye structure, and therefore, exhibits an effective antireflection function. Since scattering of visible light occurs if the period is greater than 400 nm, the stamper will not exhibit a sufficient antireflection function and will not be suitable for production of an antireflection article such as an antireflection coating.

Moreover, since the stamper of the present invention is formed from a prototype aluminum mold having an average crystal-grain diameter of 1 mm or less and an arithmetic mean surface roughness Ra of 0.05 μm or less, it will not cause a macroscopic unevenness or color unevenness on the transcribed surface and will be useful for production of a molded material for optical use.

When the stamper of the present invention aims to produce an antireflection article such as an antireflection coating, it is preferable that the period of the microasperity structure corresponds to the period not greater than the wavelength of visible light, and the pore depth is 50 nm or more and 100 nm or more. If the pore depth is 50 nm or more, the reflectance on the surface of a molded material for optical use, which is formed by transcription of the stamper, namely the transcribed surface, decreases. Moreover, the aspect ratio (= depth/period) of the pores on the stamper is preferably 1.0 or more, more preferably 1.8 or more, and most preferably 2 or more. If the aspect ratio is 1.0 or more, it is possible to form a transcribed surface having a low reflectance, and incidence-angle dependency or wavelength dependency thereof becomes sufficiently low. If the aspect ratio is high, the wavelength dependency of the reflectance on the transcribed surface decreases, and thus, color unevenness due to crystal grains also tends to decrease. Such a tendency is conspicuous when the aspect ratio is 2 or more.

Although it has been described for the case where the pores whose diameters decrease in the depth direction from an opening thereof are formed by performing the (d) pore diameter enlarging step after the (c) second oxide coating film forming step, the (d) step is not necessarily performed after the (c) step. In such a case, the formed pores have a cylindrical shape. In a molded material for optical use, which has a microasperity structure and which is produced by such a stamper, a layer having this structure serves as a low reflectance layer. Thus, it is possible to expect a reflectance mitigating effect.

A stamper mold for the stamper of the present invention may be a flat mold or a roll mold. Moreover, the surface having the microasperity structure formed thereon may be subjected to a mold releasing treatment so as to facilitate demolding. Although there is no particular restriction on the mold releasing method, examples thereof include a method of coating a silicone polymer or a fluorinated polymer, a method of depositing a fluorine compound, a method of coating a fluorine-based or fluorinated silicon-based silane coupling agent, and the like.

Moreover, although a product such as a molded material for optical use can be produced directly from the stamper of the present invention, a replica may be first produced using the stamper as a master, and a molded material for optical use may be produced from this replica. Furthermore, another replica may be produced using this replica as a master, and a molded material for optical use may be produced from the replica. As a method for producing a replica, a method can be used in which a thin film of nickel, silver, or the like is formed on a master by electroless plating, a sputtering method, or the like, electroplating (electrocasting method) is then performed with this thin film used as an electrode to deposit nickel, for example, and this nickel layer is then released from the master, thus obtaining a replica.

[Molded Material]

By using the above-described stamper having anodized alumina formed on the surface thereof, it is possible to produce a molded material having a transcribed surface to which a microasperity structure of this stamper is transcribed.

For example, an active energy ray-curable composition (hereinafter, sometimes, referred to as a curable composition) is disposed between this stamper and a transparent substrate, and the curable composition is irradiated with an active energy ray in a state where the curable composition is in contact with the stamper, thus curing the curable composition. After that, the stamper is released. As a result, a molded material is obtained in which a microasperity structure formed from the cured material is formed on the surface of the transparent substrate.

More specifically, the stamper and the transparent substrate are disposed so as to oppose each other, and the curable composition is filled and disposed between them. At that time, the stamper and the transparent substrate are disposed so that a surface (stamper surface) on which the microasperity structure of the stamper is formed opposes the transparent substrate. After that, the curable composition is irradiated with an active energy ray (visible light, ultraviolet ray, electron beam, plasma, and heat ray such as infrared ray) via the transparent substrate using, for example, a high-pressure mercury lamp or a metal hydride lamp, thus curing the curable composition. At that time, the curable composition is irradiated with the active energy ray in a state where the curable composition is in contact with the stamper. After that, the stamper is released. As a result, a molded material is obtained in which a microasperity structure formed from the cured material is formed on the surface of the transparent substrate. At that time, after the releasing, the molded material may be further irradiated with an active energy ray if necessary. Although there is no particular restriction on the irradiation energy dose insofar as curing takes place, the irradiation energy dose is typically 100 to 10000 mJ/cm$^2$.

Alternatively, the molded material of the present invention may be similarly obtained by a method in which a solid-state non-cured, active energy ray-curable composition is coated on the transparent sheet, the curable composition is pressed by a roll stamper to transcribe the microasperity structure thereto, and the non-cured curable composition is then irradiated with an active energy ray, thus curing the curable composition.

There is no particular restriction on the transparent substrate to be used herein, insofar as it does not substantially retard irradiation of the active energy ray. Examples thereof include polyethylene terephthalates (PET), methyl methacrylate (co)polymers, polycarbonates, styrene (co)polymers, methyl methacrylate-styrene copolymers, cellulose diacetates, cellulose triacetates, cellulose acetate butyrates, polyesters, polyamides, polyimides, polyether sulfones, polysulfones, polypropylenes, polymethylpentenes, polyvinylchlorides, polyvinyl acetals, polyetherketones, polyurethanes, cycloolefin polymers, glass, quartz, crystal, and the like.

There is no particular restriction on the form of the transparent substrate, but the form may be appropriately selected depending on a molded material to be produced. For example, when the molded material is an antireflection coating or the like, the transparent substrate is in a sheet form or a film form. Moreover, in order to improve cohesion with a curable composition, antistatic properties, abrasion-resistant properties, weather-resistant properties, or the like, the surface of the transparent substrate may be coated with various coatings or subjected to a corona discharge treatment.

The active energy ray-curable composition is an appropriate mixture of monomers having a radically polymerizable bond and/or a cationically polymerizable bond in the molecule, oligomers, and reactive polymers, and a nonreactive polymer may be added thereto. Moreover, an active energy ray inducible sol-gel reaction composition may be used.

There is no particular restriction on a monomer having a radically polymerizable bond, and examples thereof include, as <u>monofunctional monomers</u>: (meth)acrylate derivatives, such as methyl (meth)acrylate, ethyl (meth)acrylate, propyl (meth)acrylate, n-butyl (meth)acrylate, i-butyl (meth)acrylate, s-butyl (meth)acrylate, t-butyl (meth)acrylate, 2-ethylhexyl (meth)acrylate, lauryl (meth)acrylate, alkyl (meth)acrylate, tridecyl (meth)acrylate, stearyl (meth)acrylate, cyclohexyl (meth)acrylate, benzyl (meth)acrylate, phenoxyethyl (meth)acrylate, isobornyl (meth)acrylate, glycidyl (meth)acrylate, tetrahydrofurfuryl (meth)acrylate, allyl (meth)acrylate, 2-hydroxyethyl (meth)acrylate, hydroxypropyl (meth)acrylate, 2-methoxyethyl (meth)acrylate, and 2-ethoxyethyl (meth)acrylate; (meth)acrylic acid; (meth)acrylonitrile; styrene derivatives, such as styrene, and $\alpha$-methylstyrene; (meth)acrylamide derivatives, such as (meth)acrylamide, N-dimethyl (meth)acrylamide, N-diethyl (meth)acrylamide, and dimethylaminopropyl (meth)acrylamide; as bifunctional monomers: ethylene glycol di(meth)acrylate, tripropylene glycol di(meth)acrylate, isocyanuric acid ethylene oxide-modified di(meth)acrylate, triethylene glycol di(meth)acrylate, diethylene glycol di(meth)acrylate, neopentylglycol di(meth)acrylate, 1,6-hexanediol di(meth)acrylate, 1,5-pentanediol di(meth)acrylate, 1,3-butylene glycol di(meth)acrylate, polybutylene glycol di(meth)acrylate, 2,2-bis(4-(meth)acryloxypolyethoxyphenyl)propane, 2,2-bis(4-(meth)acryloxyethoxyphenyl)propane, 2,2-bis(4-(3-(meth)acryloxy-2-hydroxypropoxy)phenyl)propane, 1,2-bis(3-(meth)acryloxy-2-hydroxypropoxy)ethane, 1,4-bis(3-(meth)acryloxy-2-hydroxypropoxy)butane, dimethylol tricyclodecane di(meth)acrylate, ethylene oxide-added bisphenol A di(meth)acrylate, propylene oxide-added bisphenol A di(meth)acrylate, hydroxypivalic acid neopentylglycol di(meth)acrylate, divinylbenzene, and methylenebisacrylamide; as trifunctional monomers: pentaerythritol tri(meth)acrylate, trimethylolpropane tri(meth)acrylate, trimethylolpropane ethylene oxide-modified tri(meth)acrylate, trimethylolpropane propylene oxide-modified triacrylate, trimethylolpropane ethylene oxide-modified triacrylate, and isocyanuric acid ethylene oxide-modified tri(meth)acrylate; as polyfunctional monomers: a reaction mixture of condensation products of succinic acid/trimethylolethane/acrylic acid, dipentaerythtol hexa(meth)acrylate, dipentaerythtol penta(meth)acrylate, ditrimethylol propane tetraacrylate, and tetramethylol methane tetra(meth)acrylate; a bi- or higher functional urethane acrylate; and a bi- or higher functional polyester acrylate. These may be used alone or in a combination of two of more thereof.

There is no particular restriction on a monomer having a cationically polymerizable bond, and examples thereof include monomers with an epoxy group, an oxetanyl group, an oxazolyl group, a vinyloxy group, and the like, and among them a monomer with an epoxy group is particularly preferable.

Examples of the oligomers and the reactive polymers include unsaturated polyesters such as condensates of an unsaturated dicarboxylic acid and a polyhydric alcohol, polyester (meth)acrylates, polyether (meth)acrylates, polyol (meth)acrylates, epoxy (meth)acrylates, urethane (meth)acrylates, cationic polymerizable epoxy compounds, homo- or copolymers of the above-mentioned monomers having a radically polymerizable bond in the side chain, and the like.

Examples of the nonreactive polymer include acrylic resins, styrenic resins, polyurethane resins, cellulosic resins, polyvinyl butyral resins, polyester resins, thermoplastic elastomers, and the like.

Examples of the active energy ray inducible sol-gel reaction composition include, but not limited thereto, alkoxysilane compounds, alkyl silicate compounds, and the like.

The alkoxysilane compounds may be represented by $R_xSi(OR')_y$, wherein R and R' represent alkyl groups having 1 to 10 carbon atoms, and x and y are integers satisfying the relationship of x+y=4.

Specific examples thereof include tetramethoxysilane, tetra-iso-propoxysilane, tetra-n-propoxysilane, tetra-n-butoxysilane, tetra-sec-butoxysilane, tetra-tert-butoxysilane, methyltriethoxysilane, methyltripropoxysilane, methyltributoxysilane, dimethyldimethoxysilane, dimethyldiethoxysilane, trimethylethoxysilane, trimethylmethoxysilane, trimethylpropoxysilane, trimethylbutoxysilane, and the like.

The alkyl silicate compounds may be represented by $R^1O[Si(OR^3)(OR^4)O]_zR^2$, wherein $R^1$ to $R^4$ independently represent alkyl groups having 1 to 5 carbon atoms, and z represents an integer of 3 to 20.

Specific examples thereof include methyl silicate, ethyl silicate, isopropyl silicate, n-propyl silicate, n-butyl silicate, n-pentyl silicate, acetyl silicate, and the like.

The active energy ray-curable composition typically contains a polymerization initiator for curing. There is no particular restriction on the polymerization initiator, and well-known initiators can be used.

When a photoreaction is utilized, examples of the photoinitiator include: carbonyl compounds, such as benzoin, benzoin methyl ether, benzoin ethyl ether, benzoin isopropyl ether, benzoin isobutyl ether, benzil, benzophenone, p-methoxy-benzophenone, 2,2-diethoxyacetophenone, $\alpha,\alpha$-dimethoxy-$\alpha$-phenyl acetophenone, methylphenyl glyoxylate, ethyphenyl glyoxylate, 4,4'-bis-(dimethylamino)benzophenone, and 2-hydroxy-2-methyl-1-phenyl-propan-1-one; sulfur compounds, such as tetramethylthiuram monosulfide and tetramethylthiuram disulfide; 2,4,6-trimethylbenzoyl-diphenylphosphine oxide; benzoyl diethoxy-phosphine oxide; and the like. These may be used alone or in a combination of two of more thereof.

When an electron beam curing reaction is utilized, examples of the polymerization initiator include: benzophenone, 4,4-bis(diethyl amino)benzophenone, 2,4,6-trimethylbenzophenone, methyl orthobenzoyl benzoate, 4-phenylbenzophenone, t-butylanthraquinone, 2-ethylanthraquinone, thioxanthones, such as 2,4-diethylthioxanthone, isopropylthioxanthone and 2,4-dichlorothioxanthone; acetophenones, such as diethoxyacetophenone, 2-hydroxy-2-methyl-1-phenylpropan-1-one, benzyldimethylketal, 1-hydroxycyclohexyl-phenylketone, 2-methyl-2-morpholino(4-thiomethylphenyl)propan-1-one, and 2-benzyl-2-dimethylamino-1-(4-morpholinophenyl)butanone; benzoin ethers, such as benzoin methyl ether, benzoin ethyl ether, benzoin isopropyl ether, and benzoin isobutyl ether; acylphosphine oxides, such as 2,4,6-trimethylbenzoyl diphenyl phosphine oxide, bis(2,6-dimethoxybenzoyl)-2,4,4-trimethylpentyl phosphine oxide, and bis(2,4,6-trimethylbenzoyl)-phenyl phosphine oxide; methylbenzoyl formate; 1,7-bisacrydinylheptane; 9-phenylacrydine; and the like. These may be used alone or in a combination of two of more thereof.

When a thermal reaction is utilized, specific examples of the thermal polymerization initiator include: organic peroxides, such as methyl ethyl ketone peroxide, benzoyl peroxide, dicumyl peroxide, t-butyl hydroperoxide, cumene hydroperoxide, t-butyl peroxyoctoate, t-butyl peroxybenzoate, and lauroyl peroxide; azo compounds such as azobisisobutyronitrile; redox polymerization initiators obtained by combining the organic peroxide with amines, such as N,N-dimethylaniline and N,N-dimethyl-p-toluidine; and the like.

The additive amount of the polymerization initiator is 0.1 to 10 parts by mass with respect to 100 parts by mass of the active energy ray-curable composition. If the additive amount is 0.1 parts by mass or more, the polymerization occurs easily, and if the additive amount is 10 parts or less by mass, the obtained cured material will not be colored or its mechanical strength will not be degraded.

To the active energy ray-curable composition, additives, such as an antistatic agent, a mold releasing agent, a leveling agent, a slip agent, an ultraviolet absorbing agent, an antioxidizing agent, a stabilizing agent, and a fluorine compound for improving antifouling properties; fine particles; or a small amount of solvent may be added in addition to the above-mentioned components.

The molded material produced in this way is formed from a prototype aluminum mold having an arithmetic mean surface roughness Ra of 0.05 $\mu$m or less and an average crystal-grain diameter of 1 mm or less and has a transcribed surface to which the microasperity structure of the stamper having a microasperity structure on the surface thereof is transcribed in the relationship of a key hole and a key. Moreover, on this transcribed surface, there is neither macroscopic unevenness nor color unevenness resulting from the crystal grain boundary of the stamper. Therefore, such a molded material is suitable as a molded material for optical use, particularly an antireflection article such as an antireflection coating or a stereoscopic antireflection material.

When the molded material of the present invention aims to produce an antireflection article such as an antireflection coating, it is preferable that the period of the microasperity structure corresponds to the period not greater than the wavelength of visible light, and the pore depth is 50 nm or more and 100 nm or more. Moreover, the aspect ratio (= depth/period) of the pores on the stamper is preferably 1.0 or more, and more preferably 1.8 or more. If the aspect ratio is 1.0 or more, it is possible to form a transcribed surface having a low reflectance. If the aspect ratio is 1.8 or more, incidence-angle dependency or wavelength dependency thereof becomes sufficiently low.

The reflectance is preferably 2% or less, and more preferably 1% or less. Moreover, the wavelength dependency is preferably 1.5% or less in terms of the difference between the minimum reflectance and the maximum reflectance, more preferably 1.0% or less, and still more preferably 0.5% or less.

The haze of the antireflection coating is preferably 3% or less, more preferably 1% or less, and particularly preferably 0.8% or less. If the haze is beyond 3%, the sharpness of an image decreases when used in an image display device, for example.

When the molded material is an antireflection coating, the molded material is used in a state of being bonded to the surface of a target object including: image display devices, such as a liquid crystal display device, a plasma display panel, an electroluminescence display, or a cathode tube display device, a lens, a show window, a solar cell, eye-glasses, a 1/2 wave plate, a low-pass filter, a meter cover, a vehicle interior material such as a protective plate of a car navigation system, and the like.

When the molded material is a stereoscopic antireflection material, an antireflection material may be prepared in advance using a transparent substrate having a shape corresponding to the use to be used as a member that constitutes the surface of the above-mentioned target object.

Moreover, when the target object is an image display device, the antireflection coating may be bonded to a front plate thereof without being limited to the surface, and the front plate itself may be formed from the molded material of the present invention.

In addition to the above, the use examples of such a molded material include a molded material for optical use such as an optical waveguide, a relief hologram, a lens, and a polarization splitting element, a 1/2 wave plate, a low-pass filter, or a crystal device, a cell culture sheet, a superhydrophobic film, a superhydrophilic film, and the like. The superhydrophobic film can be used in a state of being bonded to the windows of automobiles, railroad vehicles, or the like or may be used as a snow suppression means or an ice suppression means of a headlamp, an illumination lamp, or the like.

Examples

Hereinafter, the present invention will be described in detail by way of examples. However, the present invention is not limited to these examples.

Moreover, various measurements were conducted according to the following method.

(1) Average Crystal-grain Diameter of Prototype Aluminum Mold

The surface of a prototype aluminum mold was subjected to an etching treatment by polishing and observed with an optical microscope. The surface areas of 100 or more crystal grains were measured using image analysis software, "Image-Pro PLUS" (Trade name of Nippon Roper Co., Ltd.). Equivalent circular diameters were calculated for the respective crystal grains, and the average equivalent circular diameter of the 100 or more crystal grains was used as the average crystal-grain diameter.

(2) Pores on Stamper

The longitudinal section or surface of a stamper having anodized alumina formed on the surface thereof was deposited with Pt for 1 minute and observed with "field emission scanning electron microscope, JSM-7400F (Trade name of JEOL Ltd.)," at an acceleration voltage of 3.00 kV. Then, the oxide coating film thickness, the pore period, the pore depth, and the pore bottom diameter (the depth at 98% depth from the surface) were measured. At that time, the mean values at 10 measurement points were calculated and used as the respective values.

(3) Height of Unevenness due to Crystal Grain Boundary and Arithmetic Mean Roughness Ra

The surface of the mold was observed with a scanning white-light interferometer 3D Profiler System, "New View 6300" (Trade name of Zygo Corp.) using a 2.5x objective lens and a 0.5x zoom lens, and the visual fields were combined to obtain observation results for a 10 mm-square area. The unevenness heights of crystal grain boundaries were measured at arbitrary 10 points selected from the 10 mm-square area, and the mean value thereof was used as the height of the crystal grain boundary.

In addition, arithmetic mean roughnesses Ra were measured at 3 points from the 10 mm-square area with a reference length of 0.5 mm, and a mean value thereof was calculated.

(4) Microasperity on Molded Material

The longitudinal section or surface of a produced molded material was deposited with Pt for 5 minutes, and the salient height and the salient height were measured using the same apparatus and under the same conditions as mentioned in the (2). At that time, the mean values at 10 measurement points were calculated and used as the respective values.

(5) Reflectance Measurement

The backside (surface having no microasperity structure formed thereon) of the produced molded material was roughened with sandpaper and painted with a matte-black spray, and was used as a sample. The relative reflectance on the surface (surface having the microasperity structure formed thereon) of the molded material was measured using "spectrophotometer, U-4000 (Trade name of Hitachi Corp.) at an incidence angle of 5° and within a wavelength range of 380 to 780 nm.

(6) Appearance Evaluation

The molded material was placed under a fluorescent light, and the surface of the molded material was observed from two perspectives of the presence of a macroscopic unevenness and color unevenness while changing the visual field from 10° to 90°.

(Macroscopic Unevenness)

○: Unable to observe with the naked eye

✕: Unevenness heights are observable with the naked eye

(Color Unevenness)

◎: Unable to observe with the naked eye
○: Rarely observed with the naked eye
△: Slightly observable with careful observation
✕: Color unevenness is observable with the naked eye

(7) Haze Measurement

The haze of the molded material was measured using a hazemeter conforming to JIS-K-7361.

<Production Example 1: Hot Forging (1)>

The prototype aluminum mold was subjected to a hot forging treatment involving 1/2U, 2S, 1/2U, and 2S using a 1000-t press machine in a state where the prototype aluminum mold is heated to 430°C.

<Production Example 2: Hot Forging (2)>

The prototype aluminum mold was subjected to a hot forging treatment involving 2S, 1/2U, 2S, and 1/2U using a 1000-t press machine in a state where the prototype aluminum mold was heated to 430°C. Subsequently, the prototype aluminum mold was further subjected to a hot forging treatment involving 2S, 1/2U, 2S, and 1/2U in a state where the prototype aluminum mold was reheated to 430°C.

<Production Example 3: Hot Forging (3)>

The prototype aluminum mold was subjected to a hot forging treatment involving 1.5S, 0.65U, 1.5S, 0.65U, 1.5S, and 0.65U using a 1000-t press machine in a state where the prototype aluminum mold was heated to 430°C. Subsequently, the prototype aluminum mold was further subjected to a hot forging treatment involving 1.5S, 0.65U, 1.5S, and 0.65U in a state where the prototype aluminum mold was reheated to 430°C.

<Production Example 4: Cold Forging>

The prototype aluminum mold was subjected to a cold forging treatment involving 1/2U, 2S, 1/2U, and 2S using a 1000-t press machine. When the temperature of the prototype aluminum mold exceeded 200°C during the cold forging treatment, the forging was stopped, and the forging treatment was performed again after cooling the prototype aluminum mold.

<Production Example 5: Combination of Hot Forging and Cold Forging>

The prototype aluminum mold was subjected to a hot forging treatment involving 2S, 1/2U, 2S, and 1/2U using a 1000-t press machine in a state where the prototype aluminum mold was heated to 430°C. Subsequently, the prototype aluminum mold was further subjected to a hot forging treatment involving 2S, 1/2U, 2S, and 1/2U in a state where the prototype aluminum mold was reheated to 430°C. The prototype aluminum mold was gradually cooled to room temperature and subjected to a cold forging treatment involving 2S, 1/2U, 2S, and 1/2U. When the temperature of the prototype aluminum mold exceeded 200°C during the cold forging treatment, the forging was stopped, and the forging treatment was performed again after cooling the prototype aluminum mold.

<Example 1>

An aluminum ingot having a purity of 99.99% was subjected to a forging treatment according to Production Example 2 and subjected to a heat treatment for 2 hours at 325°C. A prototype aluminum mold thus obtained was cut to a disk-like prototype aluminum mold with 75 mm diameter and 2 mm thickness and having an arithmetic mean surface roughness Ra of 0.02 μm and an average crystal-grain diameter of 170 μm. Then, the disk-like prototype aluminum mold was subjected to a buff-polishing treatment and was then subjected to electrolytic polishing in a mixture solution of perchloric acid and ethanol (volume ratio of 1:4).

Subsequently, the prototype aluminum mold was subjected to anodization in a 0.3-M aqueous oxalic acid solution for 30 minutes under the conditions of a bath temperature of 16°C and DC 40 V, thus forming an oxide coating film with 3 μm thickness (step (a)). The formed oxide coating film was first removed by dissolving it in a mixed aqueous solution containing 6% by mass of phosphoric acid and 1.8% by mass of chromic acid (step (b)), and another anodization was conducted under the same conditions as used in the step (a) for 30 seconds, thus forming an oxide coating film (step (c)). After that, the prototype aluminum mold was dipped in an aqueous phosphoric acid solution of 5% by mass (30°C) for 8 minutes to be subjected to a pore diameter enlarging treatment (step (d)) for enlarging pores on the oxide coating film.

The steps (c) and (d) were repeated in a total of 5 cycles (step (e)), whereby a stamper having a micro asperity structure was obtained on which tapered pores having an approximately conical shape were formed as shown in FIG. 2. The pores had a period p of 100 nm, a depth $D_{ep}$ of 190 nm, and a pore bottom diameter of 40 nm.

The microasperity structure on the stamper surface was observed with the naked eye, and a macroscopic unevenness of the crystal grain boundary was not observable.

Subsequently, the stamper was dipped in a methanol solution (0.5% by mass) of "KBM-7803" (Trade name of Shin-Etsu Chemical Co., Ltd.), which was used as a mold releasing agent, for 30 minutes, and dried in the air for 1 hour, and was then subjected to a heat treatment at 120°C for 2 hours.

Moreover, an active energy ray-curable composition having a composition below was disposed on the surface of the stamper thus released. Furthermore, a PET film, "A4300" (Trade name of Toyobo Co., Ltd.) used as a transparent substrate was stacked thereon, and the stamper was irradiated with an ultraviolet ray with an energy of 3200 mJ/cm$^2$ via this PET film in a state where the curable composition was in contact with the stamper, thus curing the curable composition.

Thereafter, a molded material including the transparent substrate and the cured material was released from the stamper.

On the surface of the cured material of the molded material thus obtained, salients were formed with a period of 100 nm and a height of 170 nm, and a microasperity structure was formed in which the microasperity structure on the stamper surface was properly transcribed. Moreover, the microasperity structure on the surface of the molded material was observed with the naked eye, and a macroscopic unevenness resulting from the crystal grain boundary on the stamper was not observable.

Moreover, the reflectance of this molded material was measured to be 0.17 to 0.84% within a wavelength range of 380 nm to 780 nm and had the good performance necessary for an antireflection article.

The appearance evaluation results and the like of a transcribed film thus obtained are shown in Table 1.

(Curable Composition)

Condensation ester of succinic anhydride/trimethylolethane acrylic acid: 45 parts by mass

Hexanediol diacrylate: 45 parts by mass
"x-22-1602" (Trade name of Shin-Etsu Chemical Co., Ltd.): 10 parts by mass
"Irgacure 184" (Trade name of Ciba Specialty Chemicals Inc.): 2.7 parts by mass
"Irgacure 819" (Trade name of Ciba Specialty Chemicals Inc.): 0.18 parts by mass

<Example 2>

An aluminum ingot having a purity of 99.90% was subjected to a forging treatment according to Production Example 5 and subjected to a heat treatment for 2 hours at 325°C. A prototype aluminum mold thus obtained was cut to a cylindrical prototype aluminum mold with an outer diameter of 200 mm, an inner diameter of 155 mm, and a length of 350 mm and having an arithmetic mean surface roughness Ra of 0.03 $\mu$m and an average crystal-grain diameter of 40 $\mu$m. Then, the cylindrical prototype aluminum mold was subjected to a sequence of processing including mirror finishing, the step (a), and the step (b) similarly to Example 1. Subsequently, another anodization was conducted under the same conditions as used in the step (a) for 35 seconds, thus forming an oxide coating film (step (c)). After that, the prototype aluminum mold was dipped in an aqueous phosphoric acid solution of 5% by mass (30°C) for 8 minutes to be subjected to a pore diameter enlarging treatment (step (d)) for enlarging pores on the oxide coating film.

The steps (c) and (d) were repeated in a total of 5 cycles (step (e)), whereby a stamper having a microasperity structure was obtained on which tapered pores having an approximately conical shape were formed as shown in FIG. 2. The pores had a period p of 100 nm and a depth $D_{ep}$ of 230 nm.

The microasperity structure on the stamper surface was observed with the naked eye, and a macroscopic unevenness of the crystal grain boundary was not observable.

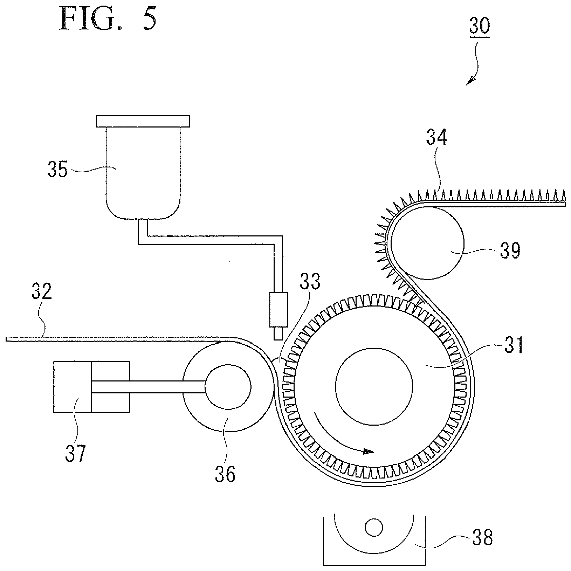

Subsequently, the stamper was subjected to a mold releasing treatment by dipping it in a solution (0.1% by mass) of "OPTOOL DSX" (Trade name of Daikin Industries, Ltd.), which was used as a mold releasing agent, for 10 minutes, and drying it in the air for 24 hours, thus obtaining a roll mold. This roll mold was placed into a molded material production apparatus 30 for continuously producing a molded material as shown in FIG. 5, thus producing a molded material.

First, a roll mold 31 was fit into a core roll which is made of carbon steel for machine structural purposes and equipped with a cooling water channel therein as shown in FIG. 5. Subsequently, the same curable composition 33 as used in Example 1 was supplied onto a transparent substrate 32 (PET film "A4300" (Trade name of Toyobo Co., Ltd.)), which was nipped between a nip roller 36 and the roll mold 31, at room temperature from a tank 35 through a supply nozzle. At that time, the curable composition 33 was also filled in the recesses of the roll mold 31 while being nipped by the nip roller 36 whose nipping pressure was adjusted by a pneumatic cylinder 37.

The roll mold 31 was irradiated with an ultraviolet ray from an ultraviolet irradiation apparatus 38 with a power of 240 W/cm while being rotated at a speed of 7.0 m/min in a state where the curable composition 33 was interposed between the roll mold 31 and the transparent substrate 32, thus curing and molding the curable composition 33. Thereafter, the roll mold 31 was released by a release roller 39 and a molded material (transparent sheet) 34 having a microasperity structure was obtained.

On the surface of the cured material of the molded material thus obtained, salients were formed with a period of 100 nm and a height of 210 nm, and a microasperity structure was formed in which the microasperity structure on the stamper surface was properly transcribed. Moreover, the microasperity structure on the surface of the molded material was observed with the naked eye, and a macroscopic unevenness resulting from the crystal grain boundary on the stamper was not observable.

Moreover, the reflectance of this molded material was measured to be 0.16 to 0.29% within a wavelength range of 380 nm to 780 nm and had good performance necessary for an antireflection article. The appearance evaluation results and the like of a transcribed film thus obtained are shown in Table 1.

<Example 3>

An aluminum ingot having a purity of 99.99% was subjected to a forging treatment according to Production Example 5 and subjected to a heat treatment for 2 hours at 325°C. Using the prototype aluminum mold thus obtained, a roll-shaped stamper was obtained similarly to Example 1. The results of the produced molded material are shown in Table 1.

<Example 4>

An aluminum ingot having a purity of 99.95% was subjected to a forging treatment according to Production Example 5 and subjected to a heat treatment for 2 hours at 340°C. Using the prototype aluminum mold thus obtained, a stamper was produced similarly to Example 2, except that the prototype aluminum mold was cut to a disk-like prototype aluminum mold with A4 size and 10 mm thickness and having an arithmetic mean surface roughness Ra of 0.02 $\mu$m and an average crystal-grain diameter of 40 $\mu$m. In addition, a molded material was produced. The results obtained are shown in Table 1.

<Example 5>

A stamper was produced similarly to Example 1, except that an aluminum ingot having a purity of 99.97% was subjected to a forging treatment according to Production Example 5 and subjected to a heat treatment for 2 hours at 380°C, and anodization was conducted for 27 seconds in the step (c). In addition, a molded material was produced. The results obtained are shown in Table 1.

<Example 6>

A stamper was produced similarly to Example 2, except that an aluminum ingot having a purity of 99.986%, and a molded material was produced. The results obtained are shown in Table 1.

<Example 7>

An aluminum ingot having a purity of 99.97% was subjected to a forging treatment according to Production Example 5 and subjected to a heat treatment for 2 hours at 340°C. Using the prototype aluminum mold thus obtained, a stamper was produced similarly to Example 2, except that the prototype aluminum mold was cut to a disk-like prototype aluminum mold with A4 size and 10 mm thickness and having an arithmetic mean surface roughness Ra of 0.02 $\mu$m and an average crystal-grain diameter of 40 $\mu$m, and the processing time in the step (a) was 90 minutes. In addition, a molded material was produced. The results obtained are shown in Table 1.

<Example 8>

A stamper was produced similarly to Example 2, except that an aluminum ingot having a purity of 99.97% was subjected to a forging treatment according to Production Example 3 and subjected to a heat treatment for 2 hours at 380°C, and anodization was conducted for 32 seconds in the step (c). In addition, a molded material was produced. The results obtained are shown in Table 1.

<Example 9>

A stamper was produced similarly to Example 4, except that anodization was conducted for 27 seconds in the step (c), and a molded material was produced. The results obtained are shown in Table 1.

<Example 10>

A stamper was produced similarly to Example 7, except that the processing time in the step (a) was 270 minutes, and a molded material was produced. The results obtained are shown in Table 1.

<Comparative Example 1>

A stamper was produced by the same method as used in Example 1, except that aluminum having an average crystal-grain diameter of 6 mm, which was obtained by cutting an aluminum ingot, was used as a prototype mold. In addition, a molded material was produced. The reflectance of this molded material was measured to be 0.30 to 0.65% within a wavelength range of 380 nm to 780 nm and have the good performance necessary for an antireflection article. However, color unevenness equivalent to a crystal grain size was observed on the molded material with the naked eye. The results obtained are shown in Table 1.

<Comparative Example 2>

A stamper was produced by the same method as used in Example 1, except that an aluminum ingot having a purity of 99.99% was subjected to a forging treatment according to Production Example 5 and cut to a disk-like prototype aluminum mold with 75 mm diameter and 2 mm thickness and having an arithmetic mean surface roughness Ra of 0.02 $\mu$m and an average crystal-grain diameter of 1.5 mm. In addition, a molded material was produced. The reflectance of this molded material was measured to be 0.35 to 0.70% within a wavelength range of 380 nm to 780 nm and have the good performance necessary for an antireflection article. However, color unevenness equivalent to a crystal grain size was observed on the molded material with the naked eye. The results obtained are shown in Table 1.

<Comparative Example 3>

A stamper was produced by the same method as used in Example 1, except that an aluminum ingot having a purity of 99.3% was subjected to a forging treatment according to Production Example 1 and cut to a disk-like prototype aluminum mold with 75 mm diameter and 2 mm thickness and having an arithmetic mean surface roughness Ra of 0.05 $\mu$m or less and an average crystal-grain diameter of 100 $\mu$m. In addition, a molded material was produced. The reflectance of this molded material was measured to be 0.35 to 0.75% within a wavelength range of 380 nm to 780 nm. However, the haze was 2.50%, which meant that the performance necessary for an antireflection article was not met. The results obtained are shown in Table 1.

<Comparative Example 4>

A rolled sheet of aluminum having a purity of 99.90% was used and subjected to electrolytic polishing by the same method as used in Example 1. Moreover, the arithmetic mean surface roughness Ra of the aluminum was 0.15 $\mu$m. After that, a stamper was produced by the same method as used in Example 1, and a molded material was produced. The reflectance of this molded material was measured to be 0.35 to 0.70% within a wavelength range of 380 nm to 780 nm. However, marks corresponding to a non-uniform structure resulting from the rolling treatment were observed in the appearance of the molded material, which meant that the performance necessary for an antireflection article was not met. The results obtained are shown in Table 1.

Table 1

| | Purity (%) | Production | Final Heat Treatment Temp. (°C) | Shape | Ra (µm) | Crystal-Grain Diameter | First Oxide Coating Thickness (µm) | Unevenness Height (nm) due to Crystal Grain Boundary | Pore Period (nm) | Depth (nm) | Pore Bottom Diameter (nm) | Aspect Ratio of Molded Material Unevenness | Within 380~780 nm Range | | Haze (%) | Appearance | |
|---|---|---|---|---|---|---|---|---|---|---|---|---|---|---|---|---|---|
| | | | | | | | | | | | | | Lowest Reflectance (%) | Highest Reflectance (%) | | Macroscopic unevenness | Color unevenness |
| Ex. 1 | 99.98 | Production Ex. 2 | 325 | Disk | 0.02 | 170 µm | 3 | 75 | 100 | 170 | 40 | 1.5 | 0.17 | 0.84 | 0.50 | ○ | ○ |
| Ex. 2 | 99.90 | Production Ex. 5 | 325 | Roll | 0.03 | 40 µm | 3 | 75 | 100 | 210 | 40 | 1.9 | 0.16 | 0.29 | 1.00 | ○ | ◎ |
| Ex. 3 | 99.99 | Production Ex. 5 | 325 | Roll | 0.03 | 100 µm | 3 | 75 | 100 | 170 | 40 | 1.5 | 0.21 | 0.70 | 0.51 | ○ | ○ |
| Ex. 4 | 99.95 | Production Ex. 5 | 340 | Planar | 0.02 | 40 µm | 3 | 75 | 100 | 230 | 40 | 2.1 | 0.07 | 0.37 | 0.51 | ○ | ◎ |
| Ex. 5 | 99.97 | Production Ex. 5 | 380 | Planar | 0.02 | 62 µm | 3 | 75 | 100 | 150 | 40 | 1.3 | 0.04 | 0.53 | 0.57 | ○ | ○ |
| Ex. 6 | 99.986 | Production Ex. 5 | 340 | Planar | 0.02 | 110 µm | 3 | 75 | 100 | 240 | 40 | 2.2 | 0.03 | 0.24 | 0.39 | ○ | ◎ |
| Ex. 7 | 99.97 | Production Ex. 3 | 340 | Planar | 0.02 | 40 µm | 10 | 250 | 100 | 210 | 40 | 1.9 | 0.18 | 0.57 | 0.53 | ○ | ○ |
| Ex. 8 | 99.97 | Production Ex. 1 | 380 | Planar | 0.02 | 240 µm | 3 | 75 | 100 | 190 | 40 | 1.9 | 0.16 | 0.60 | 0.58 | ○ | △ |
| Ex. 9 | 99.95 | Production Ex. 5 | 340 | Planar | 0.02 | 40 µm | 50 | 750 | 100 | 170 | 40 | 1.5 | 0.19 | 0.62 | 0.53 | ○ | ○ |
| Ex. 10 | 99.97 | Production Ex. 5 | 340 | Planar | 0.02 | 40 µm | 3 | 75 | 100 | 210 | 40 | 1.9 | 0.20 | 0.64 | 0.62 | × | ◎ |
| Comp. Ex. 1 | 99.99 | None | – | Disk | 0.02 | 6 mm | 3 | 75 | 100 | 230 | 40 | 2.1 | 0.30 | 0.65 | 0.64 | ○ | × |
| Comp. Ex. 2 | 99.98 | Production Ex. 5 | 325 | Disk | 0.02 | 1.5 mm | 3 | 75 | 100 | 230 | 40 | 2.1 | 0.35 | 0.70 | 0.54 | ○ | × |
| Comp. Ex. 3 | 99.30 | None | – | Disk | 0.09 | Non-uniform | 3 | 75 | 100 | 230 | 40 | 2.1 | 0.35 | 0.75 | 3.50 | × | ○ |
| Comp. Ex. 4 | 99.90 | Production Ex. 4 | 350 | Disk | 0.13 | Non-uniform | 3 | 75 | 100 | 230 | 40 | 2.1 | 0.35 | 0.70 | 1.50 | × | ○ |

Industrial Applicability

According to the present invention, it is possible not only to use a stamper which has anodized alumina on the surface thereof and which does not cause a macroscopic unevenness or color unevenness on the transcribed surface, but also to use a method for producing a molded material using such a stamper.

**Claims**

1. A stamper comprising alumina which has a microasperity structure and which is formed by anodization on a surface of a non-rolled prototype aluminum mold having an aluminum purity of 99.5 % or more, an average crystal-grain diameter of 200 $\mu$m or less, and an arithmetic mean surface roughness Ra of 0.05 $\mu$m or less.

2. The stamper according to claim 1, wherein the height difference of unevenness due to the crystal grain boundary on the surface of the stamper is 600 nm or less.

3. The stamper according to claim 1 or 2, wherein the microasperity structure of the stamper includes pores whose aspect ratio is 1.8 or more.

4. The stamper according to any one of claims 1 to 3, wherein the prototype aluminum mold contains 0.04 % or less by mass of silicon, 0.06 % or less by mass of iron, and 0.01 % or less by mass of copper with respect to 100 % by mass of the prototype aluminum mold.

5. The stamper according to any one of claims 1 to 4, wherein the prototype aluminum mold is subjected to a forging treatment.

6. The stamper according to claim 5, wherein the forging treatment is hot forging.

7. The stamper according to claim 5 or 6, wherein the forging treatment is a combination of hot forging and cold forging.

8. A method for producing a stamper having alumina having a microasperity structure formed on a surface thereof, the method comprising:

   (a) a first oxide coating film forming step of forming an oxide coating film by anodizing a non-rolled prototype aluminum mold in an electrolytic solution and at a constant voltage;
   (b) an oxide coating film removing step of removing the oxide coating film thus formed to form pore generating points for anodization;
   (c) a second oxide coating film forming step of reanodizing an intermediate aluminum mold having the pore generating points formed thereon in an electrolytic solution and at a constant voltage to form an oxide coating film having pores at the pore generating points; and
   (d) a pore diameter enlarging step of enlarging the diameters of the pores thus formed,

   wherein the non-rolled prototype aluminum mold has an average crystal-grain diameter of 200 $\mu$m or less and an arithmetic mean surface roughness Ra of 0.05 $\mu$m or less.

9. The method for producing the stamper according to claim 8, wherein the height difference of the unevenness due to the crystal grain boundary on the surface of the stamper is 600 nm or less.

10. The method for producing the stamper according to claim 8 or 9, wherein the microasperity structure of the stamper includes pores whose aspect ratio is 1.8 or more.

11. A method for producing a molded material, comprising:

    disposing an active energy ray-curable composition between the stamper according to any one of claims 1 to 7 and a transparent substrate;
    irradiating the active energy ray-curable composition with an active energy ray in a state where the active energy ray-curable composition is in contact with the stamper, thus curing the active energy ray-curable composition; and
    releasing a cured material from the stamper, thus producing a molded material in which a microasperity structure formed from the cured material of the active energy ray-curable composition is formed on a surface of the transparent substrate.

12. A method for producing a molded material, comprising:

disposing an active energy ray-curable composition between the stamper according to any one of claims 1 to 7 and a transparent substrate;
transcribing the microasperity structure on the surface of the stamper to the active energy ray-curable composition and releasing the stamper; and
irradiating the active energy ray-curable composition with an active energy ray, thus curing the active energy ray-curable composition and producing a molded material in which a microasperity structure formed from a cured material of the active energy ray-curable composition is formed on a surface of the transparent substrate.

13. The method for producing the molded material according to any one of claims 11 or 12, wherein the microasperity structure of the molded material includes protrusions whose aspect ratio is 1.8 or more.

14. The method for producing the molded material according to any one of claims 11 to 13, wherein the molded material is an antireflection article.

15. A prototype aluminum mold for the stamper according to any one of claims 1 to 7.


**Patentansprüche**

1. Stempel, der Aluminiumoxid umfasst, das eine Mikro-Rauheitsstruktur ("microasperity structure") aufweist und das durch Anodisieren auf einer Oberfläche einer nicht gewalzten Prototypaluminiumform gebildet wird, die eine Aluminiumreinheit von 99,5% oder mehr, einem mittleren Kristallkorndurchmesser von 200 $\mu$m oder weniger, und einem arithmetischen Mittenrauwert Ra von 0,05 $\mu$m oder weniger aufweist.

2. Stempel gemäß Anspruch 1, wobei die Höhendifferenz der Unebenheiten aufgrund der Kristallkorngrenze auf der Oberfläche des Stempels 600 nm oder weniger beträgt.

3. Stempel gemäß Anspruch 1 oder 2, wobei die Mikro-Rauheitsstruktur des Stempels Poren umfasst, deren Seitenverhältnis 1,8 oder mehr beträgt.

4. Stempel gemäß einem der Ansprüche 1 bis 3, wobei die Prototypaluminiumform 0,04 Massen% oder weniger an Silicium, 0,06 Massen% oder weniger an Eisen und 0,01 Massen% oder weniger an Kupfer in Bezug auf 100 Massen% der Prototypaluminiumform umfasst.

5. Stempel gemäß einem der Ansprüche 1 bis 4, wobei die Prototypaluminiumform einer Schmiedebehandlung unterzogen wird.

6. Stempel gemäß Anspruch 5, wobei die Schmiedebehandlung Warmschmieden ist.

7. Stempel gemäß Anspruch 5 oder 6, wobei die Schmiedebehandlung eine Kombination aus Warmschmieden und Kaltschmieden ist.

8. Verfahren zur Herstellung eines Stempels mit Aluminiumoxid, das eine auf einer Oberfläche davon gebildete Mikro-Rauheitsstruktur aufweist, wobei das Verfahren die folgenden Schritte umfasst:

(a) einen ersten Schritt zur Ausbildung einer Oxidüberzugsschicht, in dem eine Oxidüberzugsschicht durch Anodisieren einer nicht gewalzten Prototypaluminiumform in einer elektrolytischen Lösung und bei konstanter Spannung gebildet wird;
(b) einen Schritt zur Entfernung der Oxidüberzugsschicht, in dem die so gebildete Oxidüberzugsschicht entfernt wird, um Porenerzeugungspunkte für die Anodisierung zu bilden;
(c) einen zweiten Schritt zur Ausbildung einer Oxidüberzugsschicht, in dem eine intermediäre Aluminiumform mit den darauf gebildeten Porenerzeugungspunkten in einer elektrolytischen Lösung und bei konstanter Spannung reanodisiert wird, um eine Oxidüberzugsschicht mit Poren an den Porenerzeugungspunkten zu bilden; und

(d) einen Schritt zur Vergrößerung des Porendurchmessers, in dem der Durchmesser der so gebildeten Poren vergrößert wird,

wobei die nicht gewalzte Prototypaluminiumform einen mittleren Kristallkorndurchmesser von 200 μm oder weniger und einen arithmetischen Mittenrauwert Ra von 0,05 μm oder weniger aufweist.

9. Verfahren zur Herstellung des Stempels gemäß Anspruch 8, wobei die Höhendifferenz der Unebenheiten aufgrund der Kristallkorngrenze auf der Oberfläche des Stempels 600 nm oder weniger beträgt.

10. Verfahren zur Herstellung des Stempels gemäß Anspruch 8 oder 9, wobei die Mikro-Rauheitsstruktur des Stempels Poren umfasst, deren Seitenverhältnis 1,8 oder mehr beträgt.

11. Verfahren zur Herstellung eines Formmaterials, wobei das Verfahren die folgenden Schritte umfasst:

Aufbringen einer durch Strahlen mit wirksamer Energie härtbaren Zusammensetzung zwischen dem Stempel gemäß einem der Ansprüche 1 bis 7 und einem transparenten Substrat;
Bestrahlen der durch Strahlen mit wirksamer Energie härtbaren Zusammensetzung mit Strahlen mit wirksamer Energie in einem Zustand, in dem die durch Strahlen mit wirksamer Energie härtbare Zusammensetzung in Kontakt mit dem Stempel steht, wodurch die durch Strahlen wirksamer Energie härtbare Zusammensetzung gehärtet wird; und
Ablösen eines gehärteten Materials vom Stempel, wodurch ein Formmaterial hergestellt wird, bei dem eine Mikro-Rauheitsstruktur, die aus dem gehärteten Material der durch Strahlen wirksamer Energie härtbaren Zusammensetzung gebildet wurde, auf einer Oberfläche des transparenten Substrats gebildet wird.

12. Verfahren zur Herstellung eines Formmaterials, wobei das Verfahren die folgenden Schritte umfasst:

Aufbringen einer durch Strahlen mit wirksamer Energie härtbaren Zusammensetzung zwischen dem Stempel gemäß einem der Ansprüche 1 bis 7 und einem transparenten Substrat;
Transkribieren der Mikro-Rauheitsstruktur auf der Oberfläche des Stempels auf die durch Strahlen wirksamer Energie härtbare Zusammensetzung und Ablösen des Stempels; und
Bestrahlen der durch Strahlen wirksamer Energie härtbaren Zusammensetzung mit Strahlen wirksamer Energie, wodurch die durch Strahlen wirksamer Energie härtbare Zusammensetzung gehärtet wird und ein Formmaterial hergestellt wird, bei dem eine Mikro-Rauheitsstruktur, die aus dem gehärteten Material der durch Strahlen wirksamer Energie härtbaren Zusammensetzung gebildet wurde, auf einer Oberfläche des transparenten Substrats gebildet wird.

13. Verfahren zur Herstellung eines Formmaterials gemäß einem der Ansprüche 11 oder 12, wobei die Mikro-Rauheitsstruktur des Formmaterials Vorsprünge umfasst, deren Seitenverhältnis 1,8 oder mehr beträgt.

14. Verfahren zur Herstellung eines Formmaterials gemäß einem der Ansprüche 11 bis 13, wobei das Formmaterial ein Antireflexionsgegenstand ist.

15. Prototypaluminiumform für den Stempel gemäß einem der Ansprüche 1 bis 7.

**Revendications**

1. Matrice de pressage comprenant de l'alumine qui présente une structure de micro-aspérités et qui est formée par anodisation sur une surface d'un moule en aluminium prototype non laminé ayant une pureté en aluminium de 99,5 % ou supérieure, un diamètre moyen de grains cristallins de 200 μm ou inférieur, et une rugosité superficielle arithmétique moyenne Ra de 0,05 μm ou inférieure.

2. Matrice de pressage selon la revendication 1, dans laquelle la différence de hauteur d'irrégularité due à la limite de grains cristallins sur la surface de la matrice est de 600 nm ou inférieure.

3. Matrice de pressage selon la revendication 1 ou 2, dans laquelle la structure de micro-aspérités de la matrice comprend des pores dont le rapport de dimensions est de 1,8 ou supérieur.

**4.** Matrice de pressage selon l'une quelconque des revendications 1 à 3, dans laquelle le moule en aluminium prototype contient 0,04 % en masse de silicium ou moins, 0,06 % en masse de fer ou moins, et 0,01 % en masse de cuivre ou moins par rapport à 100 % en masse du moule en aluminium prototype.

**5.** Matrice de pressage selon l'une quelconque des revendications 1 à 4, dans laquelle le moule en aluminium prototype est soumis à un traitement de forgeage.

**6.** Matrice de pressage selon la revendication 5, dans laquelle le traitement de forgeage est un forgeage à chaud.

**7.** Matrice de pressage selon la revendication 5 ou 6, dans laquelle le traitement de forgeage est une combinaison de forgeage à chaud et de forgeage à froid.

**8.** Procédé de fabrication d'une matrice de pressage comportant de l'alumine possédant une structure de micro-aspérités formée sur une surface de celle-ci, le procédé comprenant :

(a) une première étape de formation de film de revêtement d'oxyde pour former un film de revêtement d'oxyde par anodisation d'un moule en aluminium prototype non laminé dans une solution électrolytique et à une tension constante ;
(b) une étape d'élimination de film de revêtement d'oxyde pour éliminer le film de revêtement d'oxyde ainsi formé pour former des points de génération de pores pour une anodisation ;
(c) une seconde étape de formation de film de revêtement d'oxyde consistant à ré-anodiser un moule en aluminium intermédiaire ayant les points de génération de pores formés sur celui-ci dans une solution électrolytique et à une tension constante pour former un film de revêtement d'oxyde ayant des pores au niveau des points de génération de pores ; et
(d) une étape d'agrandissement de diamètre de pore pour agrandir les diamètres des pores ainsi formés,

dans lequel le moule en aluminium prototype non laminé présente un diamètre moyen de grains cristallins de 200 $\mu$m ou inférieur et une rugosité de surface arithmétique moyenne Ra de 0,05 $\mu$m ou inférieure.

**9.** Procédé de fabrication de la matrice de pressage selon la revendication 8, dans lequel la différence de hauteur de l'irrégularité due à la limite de grains cristallins sur la surface de la matrice est de 600 nm ou inférieure.

**10.** Procédé de fabrication de la matrice de pressage selon la revendication 8 ou 9, dans lequel la structure de micro-aspérités de la matrice comprend des pores dont le rapport de dimensions est de 1,8 ou supérieur.

**11.** Procédé de fabrication d'un matériau moulé, comprenant :

- la disposition d'une composition durcissable par rayonnement énergétique actif entre la matrice de pressage selon l'une quelconque des revendications 1 à 7 et un substrat transparent ;
- l'irradiation de la composition durcissable par rayonnement énergétique actif avec un rayonnement énergétique actif dans un état où la composition durcissable par rayonnement énergétique actif est en contact avec la matrice de pressage, en durcissant ainsi la composition durcissable par rayonnement énergétique actif ; et
- le démoulage d'un matériau durci de la matrice, en fabriquant ainsi un matériau moulé dans lequel une structure de micro-aspérités formée à partir du matériau durci de la composition durcissable par rayonnement énergétique actif est formée sur une surface du substrat transparent.

**12.** Procédé de fabrication d'un matériau moulé, comprenant :

- la disposition d'une composition durcissable par rayonnement énergétique actif entre la matrice de pressage selon l'une quelconque des revendications 1 à 7 et un substrat transparent ;
- la transcription de la structure de micro-aspérités sur la surface de la matrice à la composition durcissable par rayonnement énergétique actif et le démoulage de la matrice ; et
- l'irradiation de la composition durcissable par rayonnement énergétique actif avec un rayonnement énergétique actif, en durcissant ainsi la composition durcissable par rayonnement énergétique actif et en fabriquant un matériau moulé dans lequel une structure de micro-aspérités formée à partir d'un matériau durci de la composition durcissable par rayonnement énergétique actif est formée sur une surface du substrat transparent.

**13.** Procédé de fabrication du matériau moulé selon l'une quelconque des revendications 11 ou 12, dans lequel la structure de micro-aspérités du matériau moulé comprend des protubérances dont le rapport de dimensions est de 1,8 ou supérieur.

14. Procédé de fabrication du matériau moulé selon l'une quelconque des revendications 11 à 13, dans lequel le matériau moulé est un article antireflet.

15. Moule en aluminium prototype pour la matrice de pressage selon l'une quelconque des revendications 1 à 7.

FIG. 1A

FIG. 1B

FIG. 1C

FIG. 1D

FIG. 1E

FIG. 1F

## FIG. 2

## FIG. 3

## FIG. 4

FIG. 5

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2007277855 A
- JP 2008196741 A
- JP 2005156695 A
- JP 2003043203 A
- JP 2005232487 A

**Non-patent literature cited in the description**

- **MASUDA.** *Applied Physics,* 2000, vol. 69 (5), 558